# EUROPEAN PATENT SPECIFICATION

(11) **EP 4 435 858 B1**
(45) Date of publication and mention of the grant of the patent: **17.12.2025**
(21) Application number: 23305396.6
(22) Date of filing: 23.03.2023
(51) Int. Cl.: H10D 1/68, H10D 86/85, H01L 21/28, H10D 1/47

(54) **RESISTOR-CAPACITOR COMPONENT FOR HIGH-VOLTAGE APPLICATIONS AND METHOD FOR MANUFACTURING THEREOF**
WIDERSTANDS-KONDENSATOR-BAUELEMENT FÜR HOCHSPANNUNGSANWENDUNGEN UND HERSTELLUNGSVERFAHREN DAFÜR
COMPOSANT RÉSISTANCE-CONDENSATEUR POUR APPLICATIONS HAUTE TENSION ET SON PROCÉDÉ DE FABRICATION

(43) Date of publication of application: 25.09.2024
(73) Proprietor: Murata Manufacturing Co., Ltd., Nagaokakyo-shi, Kyoto 617-8555 (JP)
(72) Inventor: IOCHEM, Sébastien, 14000 CAEN (FR); BOUVIER, Stéphane, 14610 CAIRON (FR)
(74) Representative: Cabinet Beau de Loménie

(56) References cited:
- US-A1- 2002 050 459

## Description

### Field of the invention

The present invention relates to the field of electrical devices and in particular to the field of power electronics. More precisely, the present invention concerns a resistor-capacitor component for high-voltage applications and the associated manufacturing method. The present invention is particularly advantageous for implementing power inverters for high-voltage applications, but such an application is only given as an illustrative example and should not limit the invention.

### Description of Related Art

The present invention lies within, but is not limited to, the particular context of power inverters for high-voltage applications. For example, power inverters are used in automotive applications, such as electric and hybrid cars, to convert the direct current from the high-voltage battery into alternating current to drive the electric motor. In this context, power inverters have to perform high-frequency switching of high voltages.

The high-frequency switching of the inductive load (e.g., electric motor control) produces high-voltage spikes, for instance exceeding 900V or 1200V. Therefore, resistor-capacitor components, commonly referred to as snubbers, are placed in parallel with the power switches (e.g., power transistors) of the inverters to mitigate voltage spikes produced by inductive load switching.

Typically, a resistor-capacitor component (i.e, a resistor in series with a capacitor) is implemented by soldering a discrete resistor and a discrete capacitor onto a printed circuit board. The integration density of such an implementation is not satisfying, as the discrete components are bulky and occupy a large area on the printed circuit board. Furthermore, such an implementation results in significant parasitic inductance.

Recent works have proposed electrical devices with integrated transistor and resistor-capacitor components to provide switching circuits with high integration density for power electronics. Bouvier et al (EP3680934A1), proposed an integrated resistor-capacitor component wherein the resistor is provided by the intrinsic resistivity of the top electrode of the capacitor.

The solution proposed by Bouvier et al. offers numerous advantages, including high integration density, flexibility in tuning the resistance value, and simple manufacturing using standard semiconductor manufacturing processes. The solution of Bouvier et al. could be further improved. Indeed, the high-voltage spikes damped by the resistor-capacitor component result in a heating of the component which must be controlled to guarantee a desired lifetime of the component. It follows that reducing the heating of the resistor-capacitor component would allow it to withstand even higher voltage spikes and with higher frequencies.

Further prior art is known from US 2002/050459.

Therefore, there exists a need for an electrical device including a resistor-capacitor component with high integration density and able to withstand high-voltage spikes.

### Summary of the Invention

According to an aspect, the present invention provides a resistor-capacitor component comprising:
- a capacitor comprising at least a first electrode structure and a second electrode structure separated by a dielectric structure;
- an insulating layer on the second electrode structure, the insulating layer comprising one or more contact holes distributed across a surface of the insulating layer, each of said one or more contact holes delimiting an opening onto the second electrode structure having a corrugated edge; and
- a conductive layer on the insulating layer and filling said one or more contact holes to form one or more electrical contacts with the second electrode structure.

The present invention proposes a monolithic resistor-capacitor component (i.e., a component formed on a single die or chip) with a high integration density. Indeed, the resistance of the proposed component results from the intrinsic resistivity of the second electrode structure (e.g., the top electrode) of the capacitor, such that there is no need for a separate resistor to be connected to the capacitor. The electrical contacts, formed by the conductive layer filling the contact holes of the insulating layer, with the second electrode structure (e.g., the top electrode) allow tuning the resistance value of the component with great flexibility, simply by adjusting the number and area of the contact holes. It should also be noted that the proposed resistor-capacitor component can advantageously be produced using standard semiconductor manufacturing processes.

The inventors have observed that in operation, for instance, when the resistor-capacitor component is used as a snubber to damp voltage spikes, the current density within the component is concentrated at the edges of the contacts between the conductive layer (e.g., the contact plate) and the second electrode (e.g., the top electrode). As such, the maximum temperature reached by the resistor-capacitor component during operation is located on the edges of these contacts.

It is therefore proposed in this present invention to use contacts with corrugated edges (i.e., with a corrugated contour). In other words, the edge of each of the contact holes in the insulating layer has a corrugated shape when observed from above. The contact holes (and correlatively the contacts formed by the conductive layer filling the contact holes) define respectively a cylinder extending through the entire insulating layer and whose base has a corrugated edge. In comparison with contact holes with plain edges, the proposed contact holes with corrugations on their edges allow increasing the perimeter of the contacts between the conductive layer (e.g., the contact plate) and the second electrode (e.g., the top electrode), without substantially modifying their area and thus the resistance of the component.

By using such corrugated contacts with increased perimeter (compared with a plain non-corrugated edge), the proposed solution reduces the concentration of the current density in the vicinity of the edges of the contacts since the edges are longer. As a result, the local heating of the resistor-capacitor component in these regions is reduced and the component can withstand higher voltage spikes, at higher frequencies. Improved performance in terms of component reliability and lifetime also follows as a result.

For these reasons, the present invention provides a resistor-capacitor component with a high integration density and capable of withstanding high voltages.

In a particular embodiment, each of said one or more contact holes delimits a corrugated circular opening onto the second electrode structure.

This embodiment proposes using circular contact holes with a corrugated contour (i.e., a corrugated edge). The contact holes present respectively a corrugated edge following a circular pattern such that the contact hole appears to be substantially circular, but a closer inspection of the edges reveals the corrugations.

This embodiment contributes to further reducing the heating of the resistor-capacitor component. By using corrugated circular contacts between the conductive layer (i.e., the contact plate) and the second electrode structure (i.e., the top electrode), this embodiment allows a uniform current density distribution around the contacts. For instance, in comparison to a square-shaped contact, this embodiment prevents current density concentrations near sharp edges and thus local heating of the resistor-capacitor component in these regions.

In a particular embodiment, corrugations of the edges of said one or more contact holes are formed by alternating protrusions (i.e., ridges) and recesses (i.e., valleys), each of the corrugations comprising a protrusion and a recess (i.e., a ridge and a valley).

In a particular embodiment, a number and/or a depth (i.e., a size) of the corrugations of the edges of the contact holes are set to minimize a maximum temperature of the resistor-capacitor component reached for a given power and frequency of voltage spikes.

This embodiment is advantageous in that the contacts shape is optimized to reduce heating of the resistor-capacitor component and to withstand higher voltage spikes.

The number and/or the depth of the corrugations of the contacts between the conductive layer (i.e., the contact plate) and the second electrode structure (i.e., the top electrode) of the capacitor can be optimized using numerical simulations, for instance, performed with a multiphysics simulation software based on a finite element method.

In a particular embodiment, a ratio between: a distance (i.e., a pitch) between two consecutive corrugations; and a diameter of the contact holes, is equal to or less than 30%.

We refer hereinafter to a "diameter of a contact hole" as the maximum distance between two points of the contact hole.

Numerical simulation results show that the contacts provided according to this embodiment achieve advantageous performance in terms of heating of the resistor-capacitor component. This embodiment allows minimizing the maximum temperature reached by the component for a given power and frequency of voltage spikes.

In a particular embodiment, a diameter of the contact holes is comprised between 220µm and 260µm. Furthermore, in this embodiment, the edges of the contact holes comprise respectively between 20 and 30 corrugations and/or a distance (i.e., a pitch) between two consecutive corrugations is comprised between 24µm and 40µm.

The inventors have observed that the contacts provided according to this embodiment achieve advantageous performance in terms of heating of the resistor-capacitor component. In fact, this embodiment allows the maximum temperature reached by the component for a given power and frequency of voltage spikes to be particularly low. By optimizing the number and size of the corrugations of the edges of the contacts, this embodiment contributes to further reducing the heating of the resistor-capacitor component.

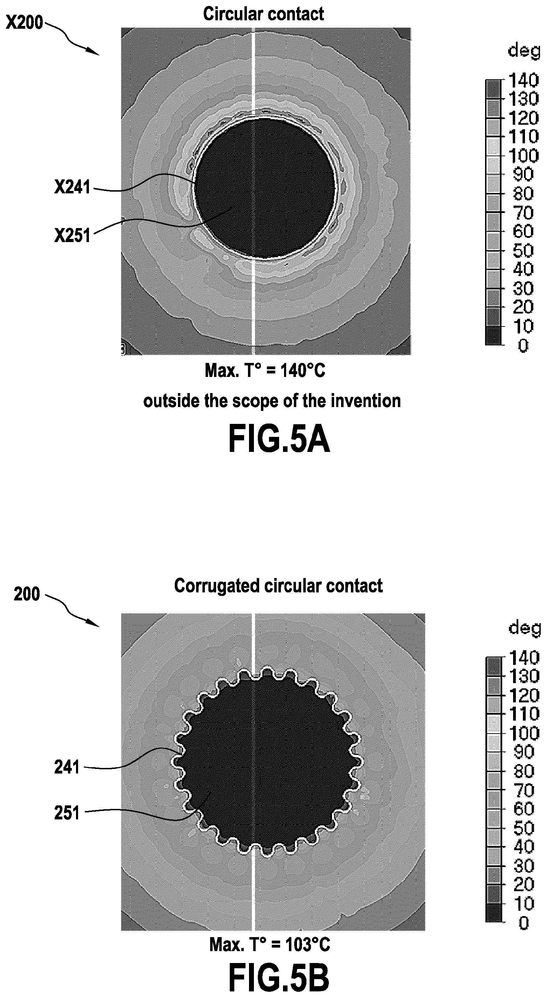

In comparison with a resistor-capacitor component using circular contacts with plain edges, this embodiment allows a reduction of approximately 36% of the maximum temperature reached by the resistor-capacitor component (detailed hereinafter in relation to FIG. 5A-5B). The use of the proposed contacts holes based on a circular corrugated shape results in a significant reduction of the heating of the component, and correlatively, in a significant improvement of its power capability.

In a particular embodiment, the protrusions (i.e., ridges) and the recesses (i.e., valleys) of the corrugations of the edges of said one or more contact holes substantially form semi-circles or arcs of circles.

This embodiment is advantageous in that the corrugations on the edges of the contact holes are smooth and present no sharp edges. This prevents current density concentrations in the vicinity of the edges of the contacts between the conductive layer (i.e., the contact plate) and the second electrode structure (i.e., the top electrode) of the capacitor. Thereby, this embodiment prevents local heating of the resistor-capacitor-component in operation.

In a particular embodiment, a ratio between: a radius of the substantially semi-circles or arcs of circles formed by the corrugations of the edges of said one or more contact holes; and a diameter of the contact holes, is equal to or less than 7.5%.

Numerical simulation results show that the contacts provided according to this embodiment achieve advantageous performance in terms of heating of the resistor-capacitor component. This embodiment allows minimizing the maximum temperature reached by the component for a given power and frequency of voltage spikes.

In a particular embodiment, a diameter of the contact holes is comprised between 220µm and 260µm and a radius of the semi-circles or arcs of circles formed by the corrugations of the edges of said one or more contact holes is comprised between 6µm and 10µm.

The inventors have observed that this embodiment allows minimizing the maximum temperature reached by the component for a given power and frequency of voltage spikes.

In a particular embodiment, a number and/or an area of said one or more contact holes of the insulating layer are set based on targeted parameters of the resistor-capacitor component including: a resistance; a bandwidth; and a maximum temperature reached for a given power and/or frequency of voltage spikes.

As previously indicated, the number and area of the contacts between the conductive layer (i.e., the contact plate) and the second electrode structure (i.e., the top electrode) of the capacitor allow tuning the resistance value of the proposed component. Thereupon, multiple configurations of the number and area of the contacts can be used to achieve the same given resistance value of the component.

For a given resistance value, this particular embodiment provides a resistor-capacitor component with optimized performance in terms of heating and bandwidth (i.e., improved response of the component to signals with fast rise times). The number and area of the contact holes can be jointly optimized using numerical simulations, for instance, performed with a multiphysics simulation software based on a finite element method.

In a particular embodiment, the capacitor of the resistor-capacitor component is a three-dimensional capacitor.

We refer here as a three-dimensional capacitor to a capacitor whose capacitive structure (i.e., the capacitor electrodes and dielectric) is formed conformally on reliefs such as pores, holes, trenches, or pillars.

The use of a three-dimensional capacitor allows achieving a high capacitance density. This embodiment is advantageous in that it provides a monolithic resistor-capacitor component with a high capacitance density and able to withstand high voltages.

In a particular embodiment, the first electrode structure comprises a semiconductor substrate with trenches, columns or holes. Specifically, in this embodiment, the dielectric structure extends conformally on the trenches, columns, or holes of the semiconductor substrate, and the second electrode structure extends conformally on the dielectric structure.

It is proposed in this embodiment to use a three-dimensional capacitor using a semiconductor substrate with trenches, holes, or columns. This embodiment thereby provides a resistor-capacitor component with a high capacitance density and able to withstand high voltages.

In addition, semiconductor substrates allow using thick dielectric layers (e.g., by using wide trenches). This would provide a capacitor with a high breakdown voltage, which is particularly suited for high-voltage applications.

In a particular embodiment, the first electrode structure comprises an anodic aluminum oxide substrate with pores and a metal layer extending conformally on the pores of the anodic aluminum oxide substrate. Further, in this embodiment, the dielectric structure extends conformally on the metal layer, and the second electrode structure extends conformally on the dielectric structure.

In this embodiment, the capacitor of the proposed component is formed by using a stack of metal-insulator-metal (MIM) layers formed within pores of a porous anodic aluminum oxide (AAO) substrate. In addition, it could be envisaged that the capacitor is formed by a repeated capacitive structure, such as a stack of MIMIM layers in pores of the substrate.

This embodiment provides a resistor-capacitor component with a high-capacitance density able to withstand high voltages, by using a three-dimensional capacitor based on a porous anodic aluminum oxide substrate.

In a particular embodiment, the resistor-capacitor component is configured to be used in an electrical circuit connected to a power supply whose voltage exceeds 600V, 900V or 1200V.

In a particular embodiment, the resistor-capacitor component is configured to be used as resistor-capacitor snubber.

According to another aspect, the present invention provides an electrical device comprising the resistor-capacitor component conforming to the invention and a transistor component. In particular, the resistor-capacitor component and the transistor component are assembled on a support (e.g., a mounting substrate) and are electrically connected.

The electrical device proposed in the present invention is particularly relevant for power switching circuits. Indeed, the proposed electrical device integrates a power transistor and a resistor-capacitor component for damping voltage spikes due to inductive load switching. In particular, the proposed electrical device is advantageous as it presents a high integration density and capable of withstanding high-voltage spikes. It should also be noted that the proposed electrical device allows the resistor-capacitor and transistor components to be closely located, thereby minimizing the parasitic inductance of the switching circuit.

According to another aspect, the present invention provides a power inverter comprising the electrical device conforming to the invention.

The power inverter is an electrical circuit configured to produce an alternating current output from a direct current supply. In a particular embodiment, the power inverter is a three-phase power inverter comprising three arms connected in parallel, each arm comprising two transistor components respectively having a snubber.

The power inverter provided by the present invention presents a high integration density and is able to withstand high operating voltages. It is particularly relevant for automotive applications (e.g., fully-electric or hybrid cars). The use of high-voltage batteries in electric vehicles would allow reducing the charging time, one of the key factors in the development of electric vehicles. In this perspective, it is essential to provide power inverters, capable of reliably withstanding high voltages and having small dimensions.

According to another aspect, the present invention provides a photomask for manufacturing a resistor-capacitor component, the photomask comprising:
- an opaque region, and one or more transparent regions distributed across a surface of the photomask, each of said one or more transparent regions having a corrugated edge; or
- a transparent region, and one or more opaque regions distributed across a surface of the photomask, each of said one or more opaque regions having a corrugated edge.

The proposed photomask is adapted to manufacture a resistor-capacitor component conforming to the invention. More particularly, the photomask is adapted to manufacture said one or more contact holes of the insulating layer of the resistor-capacitor component.

In addition, the proposed photomask can be adapted to manufacture a resistor-capacitor component according to any one of the embodiments defined in the present disclosure.

According to another aspect, the invention provides a method for manufacturing a resistor-capacitor component, the method comprising:
- obtaining a capacitor comprising at least a first electrode structure and a second electrode structure separated by a dielectric structure;
- forming an insulating layer on the second electrode structure, the insulating layer comprising one or more contact holes distributed across a surface of the insulating layer, each of said one or more contact holes delimiting an opening onto the second electrode structure having a corrugated edge; and
- forming a conductive layer on the insulating layer, the conductive layer filling said one or more contact holes to form one or more electrical contacts with the second electrode structure.

The proposed method can be adapted to manufacture a resistor-capacitor component according to any of the embodiments defined in the present disclosure.

In a particular embodiment, forming the insulating layer of the resistor-capacitor component is performed using the photomask conforming to the invention.

In a particular embodiment, the method comprises setting, using numerical simulations, a number and/or an area of said one or more contact holes of the insulating layer based on targeted parameters of the resistor-capacitor component including: a resistance; a bandwidth; and a maximum temperature reached for a given power and/or frequency of voltage spikes.

In a particular embodiment, the method comprises setting, using numerical simulations, a number and/or a depth of the corrugations of the edges of the contact holes to minimize a maximum temperature reached by the resistor-capacitor component for a given power and frequency of voltage spikes.

Further, it should be noted that the embodiments of the proposed electrical device, power inverter, photomask, and manufacturing present the advantages described above in relation to the embodiments of the proposed resistor-capacitor component.

### Brief Description of the Drawings

Further features and advantages of the present invention will become apparent from the following description of certain embodiments thereof, given by way of illustration only, not limitation, with reference to the accompanying drawings in which:
FIG. 1A-1B illustrate respectively an electrical device according to an embodiment of the invention and a power inverter according to an embodiment of the invention;
FIG. 2A-2C illustrate cross-section views of resistor-capacitor components according to embodiments of the invention;
FIG. 3A-3D illustrate the heating of resistor-capacitor components according to embodiments outside the scope of the invention;
FIG. 4 illustrates a cross-section view of a resistor-capacitor component according to an embodiment of the invention;
FIG. 5A-5B respectively illustrate the heating of a resistor-capacitor component according to an embodiment outside the scope of the invention and the heating of a resistor-capacitor component according to an embodiment of the invention;
FIG. 6A-6F illustrate steps of a method for manufacturing a resistor-capacitor component according to embodiments of the invention; and
FIG. 7A-7B illustrate photomasks for manufacturing a resistor-capacitor component according to embodiments of the invention.

### Detailed Description of Example Embodiments

Embodiments of the present invention provide a resistor-capacitor component with a high integration density suited for high-voltage applications. More specifically, embodiments of the present invention seek to reduce the heating of the resistor-capacitor component in operation.

The present invention is particularly relevant in the context of power inverters comprising a resistor-capacitor component connected to a power transistor. The following description of the invention will refer to this particular context, which is given only as an illustrative example and is not intended to limit the invention. Indeed, the present invention also applies to other uses of resistor-capacitor components, such as in power amplifiers.

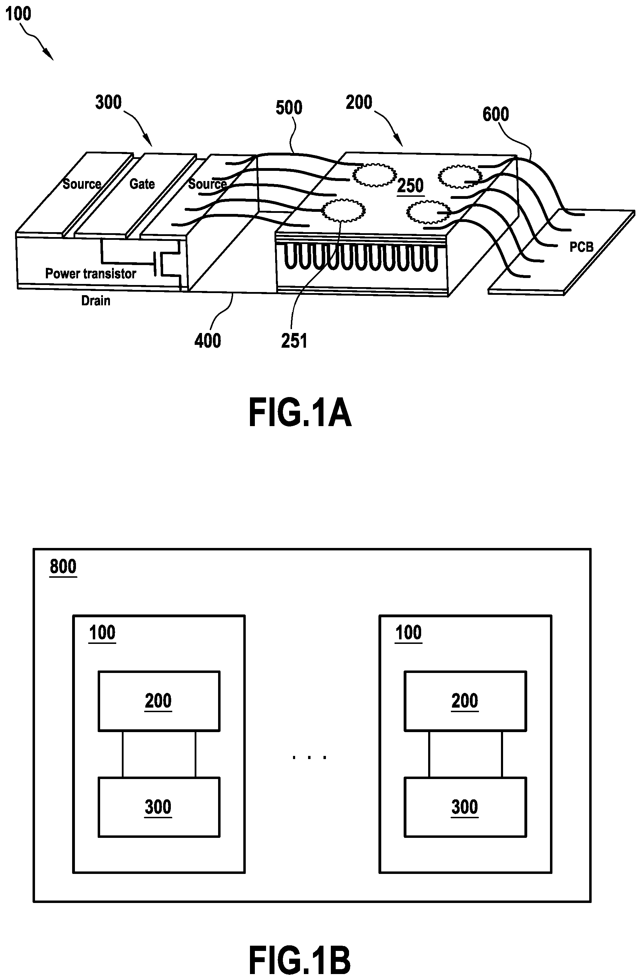

**FIG. 1A and 1B** illustrate respectively an electrical device according to an embodiment of the invention and a power inverter according to an embodiment of the invention. These figures are described hereinafter to introduce the context of the invention and provide an example application.

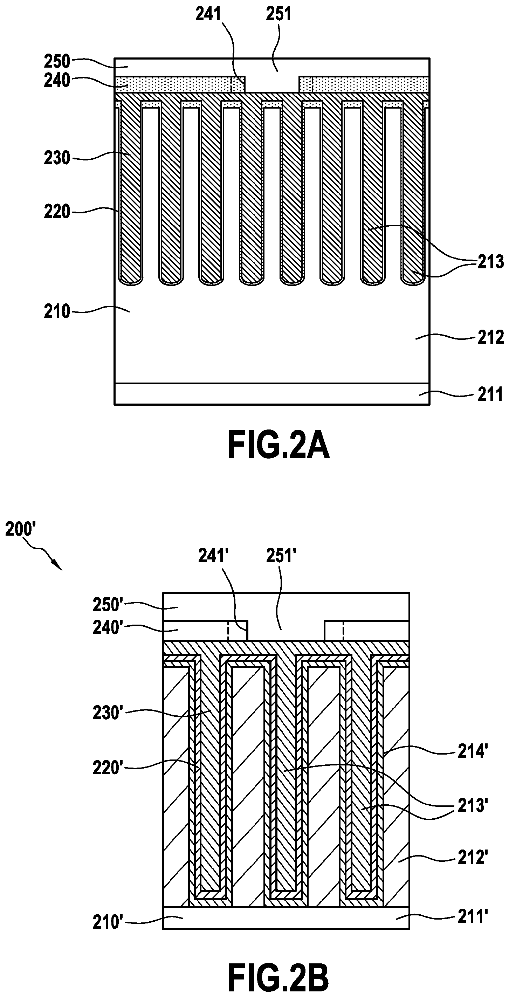

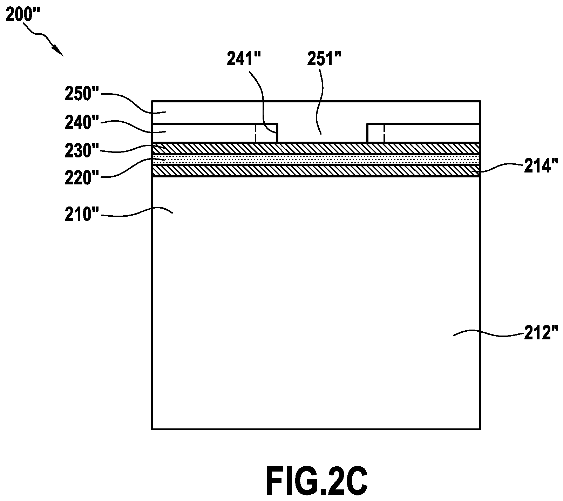

The electrical device 100 shown in FIG. 1A comprises: a resistor-capacitor component 200; a transistor 300; a support 400; and bonding wires 500 and 600. In particular, the resistor-capacitor component 200 and the transistor 300 are assembled on the support 400 and electrically connected. The architecture of the resistor-capacitor component 200 is detailed below in reference to FIG. 2.

Typically, the support 400 on which are assembled the resistor-capacitor component 200 and the transistor 300 can be a direct bonded copper (DBC) substrate. Alternatively, these components could also be manufactured on a same semiconductor substrate (e.g., a same silicon wafer).

As illustrated on this figure, the support 400 is used to interconnect the resistor-capacitor component 200 with the drain of the transistor 300, and the bonding wires 500 electrically connect the contact plate 250 (i.e., a conductive layer) of the resistor-capacitor component 200 to a source contact of the transistor 300. Bonding wires 600 can be used to electrically connect the contact plate 250 (i.e., a conductive layer) of the resistor-capacitor component 200 to a printed circuit board, thereby providing a connection to an external device such as a power supply (not represented in this figure).

This embodiment allows the resistor-capacitor component 200 and the transistor 300 to be closely located in the electrical device 100. It follows that the inductive coupling and footprint of the electrical device 100 can be minimized.

The power inverter 800 shown in FIG. 1B comprises one or more electrical devices 100. It illustrates an example application, wherein the electrical device 100 is used as a switching circuit. For instance, the power inverter 800 can be a high-voltage three-phase inverter for battery-driven electrical vehicles.

In this example application, the resistor-capacitor component 200 is used as a snubber, placed in parallel to the power transistor 300, to damp the voltage spikes produced by inductive load switching. The proximity of the resistor-capacitor component 200 and the transistor 300 results in the switching circuit having a low parasitic inductance, allowing fast switching without additional parasitic oscillation.

**FIG. 2A-2C** illustrate cross-section views of resistor-capacitor components according to embodiments of the invention. These figures detail three different architectures of the resistor-capacitor component 200 previously introduced in FIG. 1A-1B.

FIG. 2A illustrates an embodiment of the present invention wherein the resistor-capacitor component 200 comprises a three-dimensional capacitor formed by a stack of metal-insulator-semiconductor (MIS) layers using a semiconductor substrate with holes or trenches.

The resistor-capacitor component 200 comprises: a capacitor formed by a first electrode structure 210, a second electrode structure 230, and a dielectric structure 220 interposed between the first and second electrode structures.

As shown in FIG. 2A, the first electrode structure 210 forming the bottom electrode of the capacitor comprises in this embodiment: a semiconductor substrate 212 with trenches or holes 213; and a backside metallization 211. The substrate 212 is for instance a doped silicon substrate. The trenches or holes 213 extend downwards from a top surface of the substrate 212 and can be formed using photolithographic processes. The backside metallization 211 is provided by a conductive layer on the bottom surface of the substrate 212. This conductive layer may be soldered or sintered to a conductive support such as a direct bonded copper substrate (see for example FIG. 1A).

The dielectric structure 220 may comprise one or more dielectric layers extending conformally on the holes or trenches 213 of the substrate 212. For instance, the dielectric structure 220 may comprise: a silicon dioxide (SiO2) layer formed by thermal oxidation; and/or a silicon nitride (Si3N4) layer; and/or an additional silicon dioxide (SiO2) layer. It should also be noted that semiconductor substrate 212 allows using thick dielectric layers (e.g., by using wide holes or trenches). This allows providing a capacitor with a high breakdown voltage, which is essential for high-voltage applications.

As shown on FIG. 2A, the second electrode structure 230 forming the top electrode comprises a conductive layer (e.g., a layer of polysilicon) extending conformally on the dielectric structure 220. In particular, the second electrode structure 230 fills the holes or trenches 213 such that the top surface of the second electrode structure 230 lies above the top surface of the dielectric structure 220.

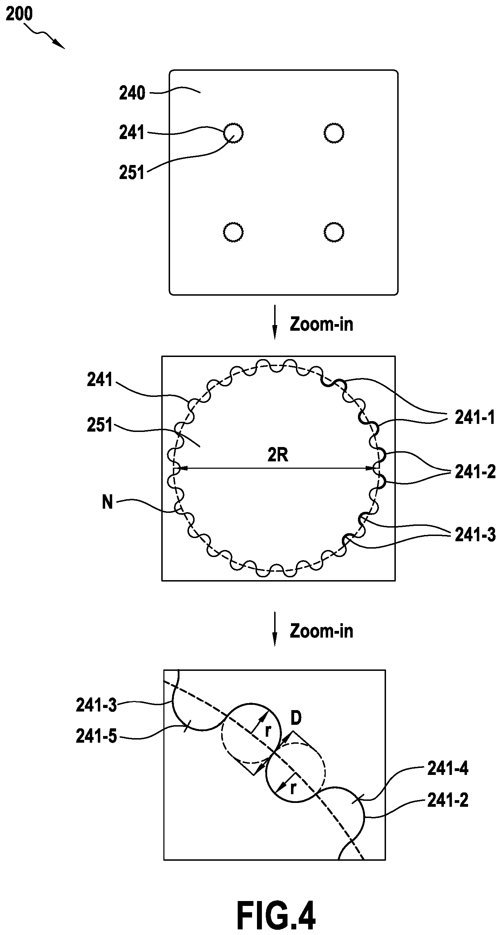

In addition, the resistor-capacitor component 200 comprises an insulating layer 240 (also referred to as the contact opening layer) on the second electrode structure 230. The insulating layer 240 comprises contact holes 241 opening onto the second electrode structure 230. In particular, each of the contact holes 241 has a corrugated edge. We describe the shape of the contact holes in further detail in relation to FIG. 4.

The resistor-capacitor component 200 comprises also a conductive layer 250 (also referred to as the contact plate) extending on the insulating layer 240 and filling the contact holes 241 so as to form electrical contacts 251 with the second electrode structure 230. Precisely, the contacts 251 correspond to the regions of the conductive layer 250 filling the contact holes 241 so as to electrically connect the conductive layer 250 with the second electrode structure 230. For example, the conductive layer 250 can be a layer of Aluminum (Al) or copper (Cu). The conductive layer 250 can be used as a contact plate to electrically connect the resistor-capacitor component 200 to other components in an electrical device (see for example FIG. 1A).

The present invention proposes a monolithic resistor-capacitor component 200 with a high integration density (i.e., a resistor-capacitor component formed on a single die). The resistance of the component 200 results from the intrinsic resistivity of the second electrode structure 230 (i.e., the top electrode) of the capacitor. The contacts 251 between the conductive layer 250 and the second electrode structure 230 allow tuning the resistance value of the component 200 with great flexibility, simply by adjusting the number and area of the contact holes 241.

Further information regarding how to obtain a desired value of the resistance of the resistor-capacitor component, in particular by adjusting the number and area of the contact holes, may be found in Bouvier et al. (EP3680934A1).

FIG. 2B illustrates another embodiment of the present invention wherein the resistor-capacitor component 200' comprises a three-dimensional capacitor formed by a stack of metal-insulator-metal (MIM) layers in a porous anodic aluminum oxide (AAO) substrate.

The resistor-capacitor component 200' of FIG. 2B differs from the resistor-capacitor component 200 of FIG. 2A in that its capacitor is formed differently. More specifically, the first electrode structure 210' is different, as will now be detailed.

As shown in FIG. 2B, the first electrode structure 210' (i.e., the bottom electrode) of the capacitor comprises: an anodic aluminum oxide substrate 212' (Al2O3) with pores 213'; a metal layer 214'; and an underlying conductive layer 211'.

In particular, the pores 213' extend from the top surface of the substrate 212' all the way through to the bottom surface of the substrate 212'. The metal layer 214' (e.g., an aluminum layer) extends conformally on the pores 213' of the substrate 212' and is in electrical contact with the underlying conductive layer 211' formed on the bottom surface of the substrate 212'.

In addition, the dielectric structure 220' extends conformally on the metal layer 214'. Then, the second electrode structure 230' (i.e., the top electrode) of the capacitor extends conformally on the dielectric structure 220' such that the top surface of the second electrode structure 230' lies above the top surface of the dielectric structure 220'.

Some further examples of manufacturing and integration of three-dimensional capacitors using porous regions of an anodic oxide substrate may be found in Voiron et al. (EP3063789A1).

FIG. 2C illustrates another embodiment of the present invention wherein the resistor-capacitor component 200" comprises a planar capacitor formed by a stack of metal-insulator-metal (MIM) layers on a substrate.

As shown in FIG. 2C, the first electrode structure 210" (i.e., the bottom electrode) of the resistor-capacitor component 200" is formed by a metal layer 214" extending on a substrate 212". The dielectric structure 220" is formed on the metal layer 214" and the second electrode structure 230" (i.e., the top electrode) is formed on the dielectric structure 220".

It is essential to note that the resistance of the components 200' and 200" respectively illustrated in FIG. 2B and 2C can be adjusted to a targeted value by setting the number and area of the contact holes 241', 241" as previously discussed in reference to FIG. 2A.

Additional Variants: Within the scope of the invention, it could also be contemplated embodiments wherein the proposed resistor-capacitor component comprises a capacitor formed by a repeated capacitive structure, such as a stack of MIMIM layers in pores of a substrate. The proposed resistor-capacitor component could also use other types of three-dimensional capacitors, for instance, capacitors formed using a substrate with pillars, columns, etc.

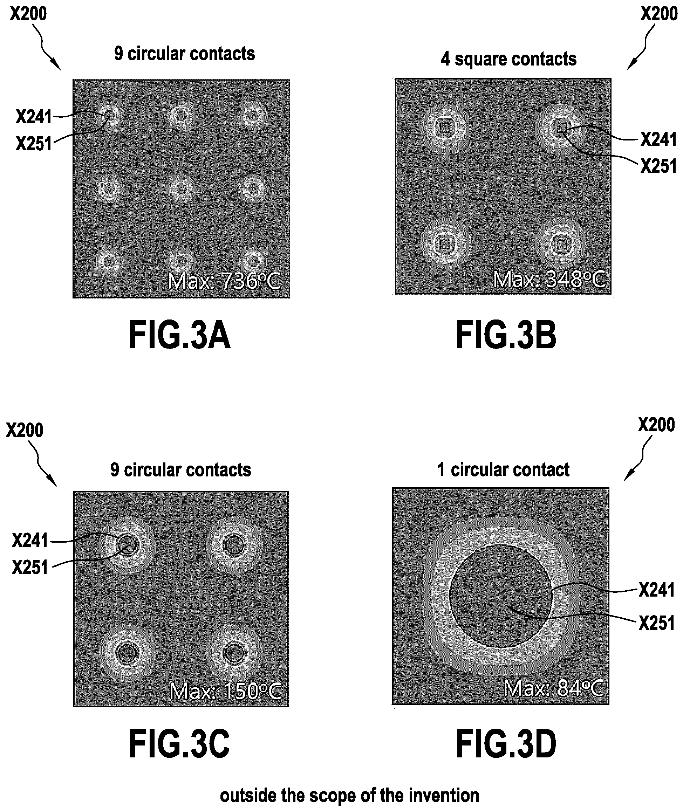

**FIG. 3A-3D** illustrate the heating of resistor-capacitor components according to embodiments outside the scope of the invention. Although these figures illustrate embodiments outside the scope of the invention, they are described below to present the inventors' findings and the underlying principle of the present invention.

These figures depict the temperatures reached by the different resistor-capacitor components X200 in operation (i.e., for a given power and frequency of voltage spikes). The results shown here have been obtained using numerical simulations produced by a multiphysics software simulation based on a finite element method.

Specifically, the results shown in FIG. 3A-3D and FIG. 5A-5B have been obtained by performing simulations with the following values. The signal applied to the terminals of the resistor-capacitor components is a signal with a triangular waveform and a period of 150ns. The maximum power of the signal is 2000W. In these simulations, the resistor-capacitor components have a resistance of 5Ω and therefore the maximum current intensity of the signal is 20A. However, the present invention is not limited to these specific simulation values, and extends to other implementation scenarios.

The different resistor-capacitor components X200, whose heating is illustrated in these figures, use different configurations for the contacts between the conductive layer and the second electrode structure. These components X200 lie outside the scope of the invention because they use contacts X251 with plain non-corrugated edges. The reference signs associated with these components start with an X to emphasize that they lie outside the scope of the invention.

As explained above, the number and area of the contacts (and correlatively of the contact holes) can be adjusted to obtain a targeted resistance value of the resistor-capacitor component. Still, multiple configurations (i.e., different numbers, areas, and shapes) of the contacts can be used to obtain the same targeted resistance value. For example, the different embodiments illustrated on FIG. 3A-3D presents all a resistance value of 5Ω.

The inventors have observed that for a given resistance value, the selection between the different possible contact configurations involves a trade-off between the bandwidth and the selfheating of the resistor-capacitor component. A resistor-capacitor component using a large number of contacts as shown in FIG. 3A exhibits a large bandwidth but reaches a high maximum temperature in operation. In contrast, a resistor-capacitor component using a low number of contacts as shown in FIG. 3D reaches a low maximum temperature in operation but exhibits a narrow bandwidth.

On the one hand, a resistor-capacitor component using a large number of contacts having small areas will exhibit an improved response to signals with fast rise times, in comparison with a resistor-capacitor component using few contacts having large areas.

The capacitive surface elements (e.g., holes or trenches) located directly under the contacts present limited resistive access. For this reason, when using contacts having large areas, there are more capacitive surface elements located directly under the contacts with limited resistive access. It follows that, when using contacts having large areas, the resistance of the component decreases at high-frequency.

In other words, the use of a large number of contacts having small areas allows maintaining the desired behavior (i.e., the desired resistance) of the resistor-capacitor component over a large bandwidth.

On the other hand, the inventors have observed that the current density is concentrated at the edges of the contact. The maximum temperature reached by the resistor-capacitor component during operation is hence located in these regions. This can be observed on FIG. 3A-3B as the isotherms delimit the edges of the contacts.

To explain why the current density is concentrated at the edges of a contact, let us consider any of the surface elements of the second electrode structure located outside the contact (i.e., located under the insulating layer, and not under the contact). In this case, the shortest path (i.e., the path of least resistance for current flow) between the considered surface element and the contact plate passes through the edge of the contact. For this reason, the current density concentrates on the edges of the contacts between the conductive layer and the second electrode structure.

As illustrated in FIG. 3A-3D, the results obtained by the inventors show that the use of contacts with larger perimeters reduces the maximum temperature reached by the resistor-capacitor component. The use of contacts with a large perimeter allows reducing the current density concentration on the edges of these contacts and reducing the heating of the component.

The inventors' findings also show that using contacts with sharp edges would result in current density concentrations and local heating of the resistor-capacitor component near the sharp edges. For example, it can be seen on FIG. 3B and 3C that the maximum temperature reached by the resistor-capacitor component with square-shaped contacts is higher than the maximum temperature reached by the resistor-capacitor component with circular contacts.

Now that the inventors' findings have been presented, we detail the solution proposed in this present invention in relation to the following figure.

**FIG. 4** illustrates a cross-section view of a resistor-capacitor component according to an embodiment of the invention. More precisely, this figure illustrates the contacts 251 formed by the conductive layer 250 filling the contact holes 241 in the resistor-capacitor component 200.

The conductive layer 250 fills the contact holes 241 in the insulating layer 240 to provide contacts 251 with the second electrode structure 230. Accordingly, the shape of those contacts 251 is substantially identical to the shape of the contact holes 241. The description of the shape of the contact holes 241 presented below also applies to the shape of the contacts 251.

It is important to note that the proposed shape of the contact holes 241 is directly based on the inventors' findings presented above in reference to FIG. 3.

Contact Holes with Corrugated Edges: The present invention proposes using contact holes 241 having corrugated edges in view of reducing the heating of the resistor-capacitor component 200.

To illustrate the shape of the proposed contact holes, let us consider that these contact holes 241 are observed from a top point of view as shown in FIG. 4. In this case, the edges (i.e., the contours, the circumferences) of the contact holes 241 present corrugations 241-1. In other words, a contact hole 241 defines a cylinder extending through the entire insulating layer 240 and whose base surface presents a corrugated edge (i.e., a corrugated contour, a corrugated circumference).

The use of corrugations 241-1 on the edges of the contact holes 241 allows increasing the perimeter of the contacts 251 between the conductive layer 250 and the second electrode structure 230 in the resistor-capacitor component 200.

As previously discussed, the maximum temperature reached by the resistor-capacitor component 200 is located near the edges of the contacts 251. Increasing the perimeter of contact holes 241 results in a reduction of the maximum temperature reached by the resistor-capacitor component. The reduction of the heating of the resistor-capacitor component 200 induced by the use of the proposed contact holes 241 with corrugated edges is illustrated by FIG. 5A-5B and detailed in reference to these figures.

Furthermore, as illustrated on FIG. 4, the use of corrugations 241-1 allows increasing the perimeter of the contact holes 241-1 without substantially modifying their area. This is particularly important since the area of the contact holes 241 contributes to define the resistance value and bandwidth of the resistor-capacitor component 200.

The proposed solution allows the resistor-capacitor component 200 to withstand higher voltage spikes, without modifying the characteristics of the component including its resistance, its capacitance, its bandwidth, the die size. In addition, the proposed resistor-capacitor component 200 can be produced using standard semiconductor manufacturing processes.

Contact Holes with a Corrugated Circular Shape: In the particular embodiment of FIG. 4, the contact holes 241 present a corrugated circular shape to further reduce the heating of the resistor-capacitor component 200.

According to this particular embodiment, contact holes 241 delimit openings onto the second electrode structure 230 with a corrugated circular shape. In other words, a contact hole 241 here defines a cylinder extending through the entire insulating layer 240 and the base surface of this cylinder is a circle whose edge is corrugated.

The use of corrugated circular contact holes 241 allows the current density to be uniformly distributed around the contacts 251. In comparison to a square-shaped contact, this embodiment prevents current density concentrations near sharp edges and thus local heating of the resistor-capacitor component in these regions - see for instance FIG. 3B and 3C.

The contact holes 241 proposed here with a corrugated circular shape contribute to further reducing the heating of the resistor-capacitor component 200.

Corrugations forming Semi-Circles: FIG. 4 illustrates a particular embodiment of the invention wherein the corrugations 241-1 on the edges of the contact holes 241 form substantially semi-circles to reduce the heating of the resistor-capacitor component 200.

The corrugations 241-1 of the contact holes 241 are formed by alternating protrusions 241-2 (i.e., ridges) and recesses 241-3 (i.e., valleys). Each corrugation 241-1 comprises one protrusion 241-2 and one recess 241-3.

In the particular embodiment of FIG. 4, the protrusions 241-2 and recesses 241-3 of the corrugations 241 are formed by semi-circles, or substantially semi-circles. According to this embodiment, the corrugations 241-1 are smooth and present no sharp edges. This prevents current density concentrations and local heating of the resistor-capacitor-component 200.

Optimization of the Corrugations using Numerical Simulations: In a particular embodiment of the invention, the number N of corrugations 241-1 on the edges of the contact holes 241 are determined using numerical simulations to minimize the maximum temperature of the resistor-capacitor component 200 in operation (i.e., the maximum temperature reached by the component for a given power and frequency of voltage spikes).

Similarly, the depth D of the corrugations 241-1 on the edges of the contact holes 241 can be determined using numerical simulations to minimize the maximum temperature of the resistor-capacitor component in operation. The depth D of the corrugations 241-1 is defined by the distance between: the crest 241-4 of a protrusion 241-2; and the trough 241-5 of the adjacent recess 241-3.

In the particular embodiment of FIG. 4, wherein the corrugations 241-1 are formed by semi-circles, the radius r of the semi-circles can be determined using numerical simulations to minimize the heating of the resistor-capacitor component 200. In fact, setting the radius r of the semi-circles define both the number N of corrugations 241-1 on the contact holes 241 and their depth D.

In particular, the parameters (i.e., the number N, the depth D, and/or the radius r) of corrugations 241-1 on the edges of the contact holes 241 can be optimized using numerical simulations.

These embodiments allow providing contact holes 241 optimized to minimize the heating of the resistor-capacitor component and to withstand higher voltage spikes.

In a particular embodiment, the contact holes 241 present a corrugated circular shape based on a reference circle of radius R (in dashed line on FIG. 4) and the corrugations 241-1 form substantially semi-circles of radius r. In this embodiment, the ratio between the radius r of the corrugations 241-1 and the radius R of the contact holes 241 is less than 15%. Numerical simulation results show that the contacts provided according to this embodiment achieve advantageous performance in terms of heating of the resistor-capacitor component.

An example implementation of the proposed resistor-capacitor component 200 is now described in reference to FIG. 4.

In this example implementation, the insulating layer 240 comprises four contact holes 241 evenly distributed on its surface. The contact holes 241 (and correlatively the contacts 251) present a corrugated circular shape based on a reference circle (in dashed line on FIG. 4) whose radius R is substantially equal to 120µm. The contact holes 241 comprise here respectively 24 corrugations 241-1 formed by substantially semi-circles. The radius r of the corrugations 241-1 is substantially equal to 7.5µm. With respect to a circular contact hole (represented in dashed line on FIG. 4), the corrugations 241-1 increase the perimeter of the contact holes 241 by approximately 51%.

The inventors have observed that the contacts provided according to this particular implementation achieve advantageous performance in terms of heating of the resistor-capacitor component 200.

Additional Variants: Though the present invention is described here in reference to the embodiment illustrated in FIG. 4, the present invention is not limited to this particular embodiment. The present invention also extends to other configurations of the contact holes within the scope of the claims.

In particular, the present invention applies to resistor-capacitor components using any number of contact holes with various areas. The contact holes may also present different shapes such as the corrugated circular shape presented above, a corrugated ellipsoidal shape, or a corrugated square-shaped contact, etc. The contact holes can be distributed evenly on the surface of the insulating layer or unevenly.

In addition, within the scope of the invention, it could also be contemplated embodiments wherein others types of corrugations are used to form the corrugated edges of the contact holes such as sine-wave corrugations. The present invention is neither limited to a particular number of corrugations on the edges of the contact holes, nor to specific values for the pitch and depth of the corrugations.

**FIG. 5A-5B** respectively illustrate the heating of a resistor-capacitor component according to an embodiment outside the scope of the invention and the heating of a resistor-capacitor component according to an embodiment of the invention.

The results of numerical simulations shown in these figures compare: the temperature reached in operation by a resistor-capacitor component X200 using circular contacts X251 (without corrugated edges) according to an embodiment outside the scope of the invention; and the temperature reached in operation by a resistor-capacitor component 200 using corrugated circular contacts 251 according to the embodiment of the invention shown in FIG. 4. The temperatures shown in these figures correspond to the temperatures reached by the second electrode structure (e.g., a polysilicon layer) of the resistor-capacitor components in operation.

Specifically, the resistor-capacitor component X200 of FIG. 5A using circular contacts X251 reaches a maximum temperature of 140°C, whereas the resistor-capacitor component 200 of FIG. 5B using corrugated circular contacts 251 reaches a maximum temperature of 103°C. This represents a significant reduction in heating of the resistor-capacitor component (here, approximately a reduction of 36% the maximum temperature). The use of the proposed contacts based on a circular corrugated shape results in a significant improvement of the power capability (here, approximately 36%).

As previously discussed, the use of contact holes 241 with corrugated edges allows increasing the perimeter of the contacts 251 between the conductive layer 250 and the second electrode structure 230. The proposed solution reduces the concentration of the current density near the edges of the contacts 251. As confirmed by the numerical simulation results shown in these figures, this reduces the local heating of the resistor-capacitor component 200 in these regions.

For these reasons, the present invention provides a resistor-capacitor component able to withstand higher voltage spikes at higher frequencies. Improved performance in terms of component reliability and lifetime also follows as a result.

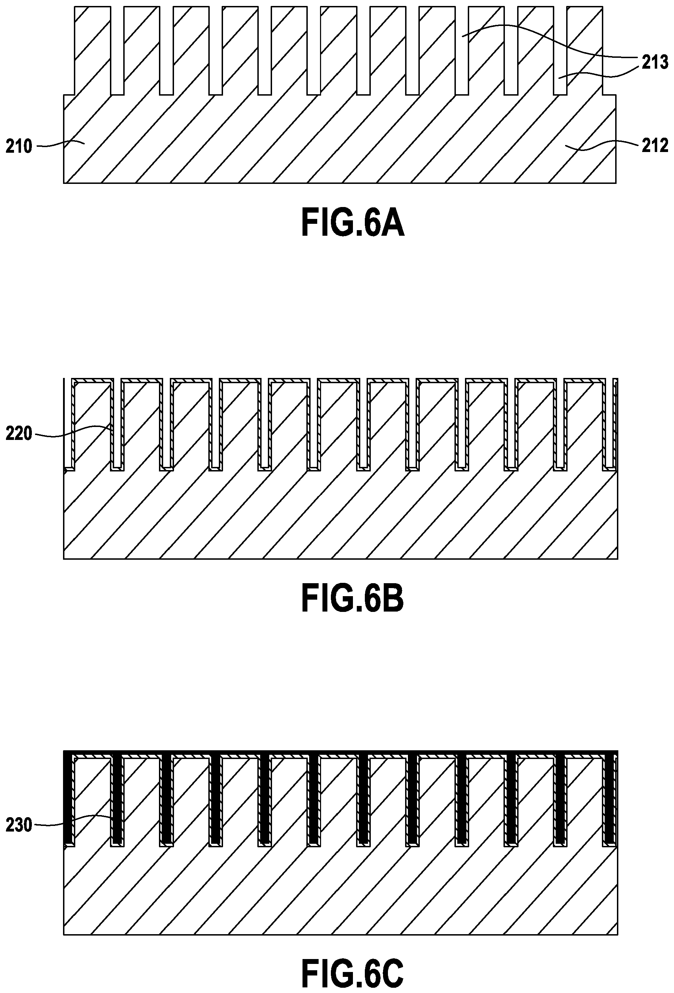

**FIG. 6A-6F** illustrate steps of a method for manufacturing a resistor-capacitor component according to embodiments of the invention. More specifically, these figures detail the manufacturing of the resistor-capacitor component 200 illustrated in FIG. 2A.

In FIG. 6A, a step is shown in which the substrate 212 of the first electrode structure 210 (bottom electrode of the capacitor) is formed. As illustrated on this figure, the substrate 212 comprises holes or trenches 213. Typically, the substrate 212 may be formed using an etching mask and dry anisotropic etching (e.g., deep reactive ion etching), then the etching mask may be removed using selective etching.

In FIG. 6B, a step is shown in which the dielectric structure 220 is formed. In particular, one or more dielectric layers (e.g., SiO2, Si3N4, and SiO2) forming the dielectric structure 220 are deposited so as to extend conformally on and coat the holes or trenches 213 of the substrate 212. For example, these dielectric layers may be formed using low-pressure chemical vapor deposition (LPCVD) or atomic layer deposition (ALD).

In FIG. 6C, a step is shown in which the second electrode structure 230 (top electrode of the capacitor) is formed. The second electrode structure 230 may be formed by depositing a conductive layer (e.g., a layer of polysilicon) extending conformally on the dielectric structure 220. This conductive layer may be deposited using chemical vapor deposition (CVD). Other conductive materials such as titanium nitride (TiN) could be used to form the second electrode structure 230.

In particular, the second electrode structure 230 fills the holes or trenches 213 such that the top surface of the second electrode structure 230 lies above the top surface of the dielectric structure 220. The second electrode structure 230 forms a film layer of conductive material above the surface of the dielectric structure 220.

As previously indicated, the capacitor of the proposed resistor-capacitor component 200 is formed by the first electrode structure 210 and the second electrode structure 230 separated by the dielectric structure 220. The resistor of the proposed resistor-capacitor component 200 is in particular provided by the second electrode structure 230, e.g., a polysilicon layer whose sheet resistance defines the overall resistance of the component 200.

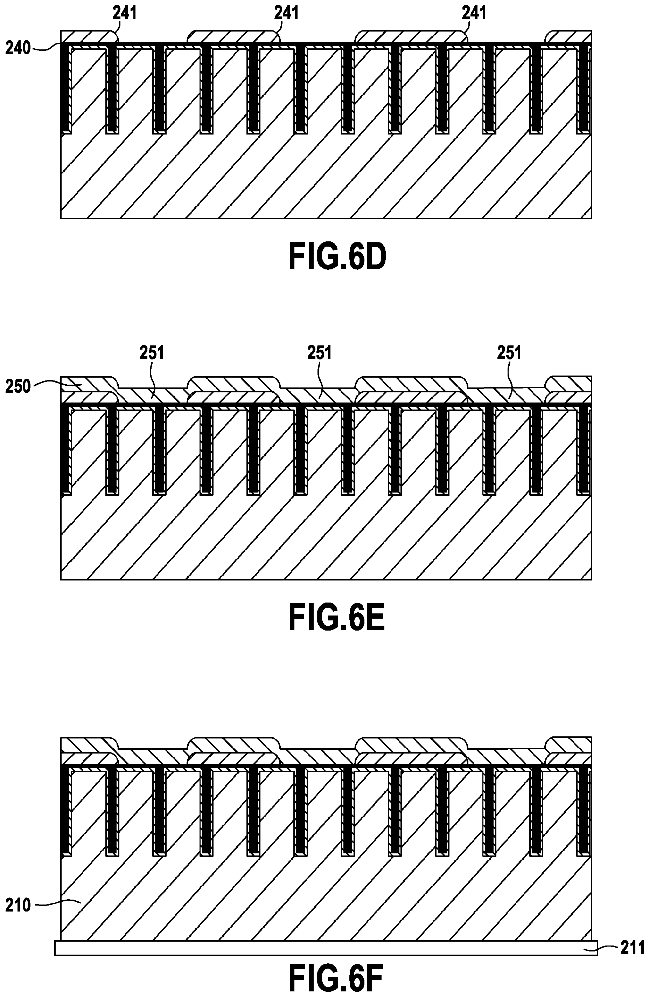

In FIG. 6D, a step is shown in which the insulating layer 240 (i.e., the contact opening layer) is formed on the second electrode structure 230. For example, the insulating layer 240 may be made of silicon oxide (SiO2) and may be deposited using plasma-enhanced chemical vapor deposition (PECVD), or any other convenient depositing technique.

As illustrated on this figure, the insulating layer 240 comprises contact holes 241 opening onto the second electrode structure 230. More particularly, forming the contact holes 241 in the insulating layer 240 can be realized by using one of the photomasks shown in FIG. 8A and 8B, as detailed hereinafter in reference to these figures.

In FIG. 6E, a step is shown in which the conductive layer 250 (i.e., the contact plate) is formed. The conductive layer 250 is deposited on the insulating layer 240 and fills the contact holes 241 so as to form the electrical contacts 251 with the second electrode structure 230 (i.e., the top electrode of the capacitor). The conductive layer 250 can be formed by depositing a conductive material, for instance, Aluminum (Al), using chemical vapor deposition (CVD) or physical vapor deposition (PVD).

Within the scope of the invention, it could also be contemplated embodiments wherein forming the conductive layer 250 comprises: depositing a first conductive material so as to fill the contact holes 241 and form the electrical contacts 251 with the second electrode structure 230; and then depositing a second conductive material (different or not from the first conductive material) so as to extends on the insulating layer 240 and on the first conductive material.

In FIG. 6F, a step is shown in which backside metallization 211 of the first electrode structure 210 is formed. This backside metallization 211 is provided by a conductive layer formed on the bottom surface of the substrate 212 (i.e., the opposite surface on which is deposited the dielectric structure 220).

Additional Variants: The manufacturing method described above illustrates one embodiment of the present invention, and other manufacturing methods could also be used to obtain the proposed resistor-capacitor component. In addition, it should be mentioned that the proposed manufacturing method can be adapted to obtain any one of the resistor-capacitor components defined in the present claims.

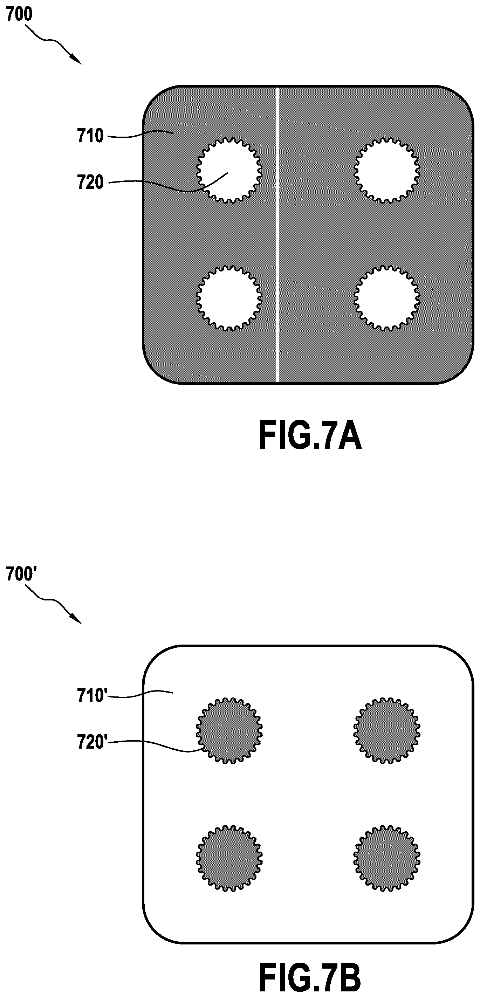

**FIG. 7A-7B** illustrate photomasks for manufacturing a resistor-capacitor component according to embodiments of the invention. Specifically, these figures depict photomasks that can be used to form the contact holes 241 in the insulating layer 240 of the resistor-capacitor component 200.

The contact holes 241 may be formed using photolithographic processes. If the photolithographic process uses positive photoresist material, the photomask of FIG. 7A is to be used to form the contact holes 241; otherwise, if negative photoresist material is used, the photomask of FIG. 7B is to be used.

Additional Variants: Although the present invention has been described above with reference to certain specific embodiments, it will be understood that the invention is not limited by the particularities of the specific embodiments. Numerous variations, modifications, and developments may be made in the above-described embodiments within the scope of the claims.

It is to be understood that references in this text to directions and locations, such as "top" and "bottom", merely refer to the directions that apply when architectures and components are oriented as illustrated in the accompanying drawings.

## Claims

1. A resistor-capacitor component (200) comprising:
- a capacitor comprising at least a first electrode structure (210) and a second electrode structure (230) separated by a dielectric structure (220);
- an insulating layer (240) on the second electrode structure (230), the insulating layer (240) comprising contact holes (241) distributed across a surface of the insulating layer (240), each of the contact holes (241) delimiting an opening onto the second electrode structure (230) having a corrugated edge; and
- a conductive layer (250) on the insulating layer (240) and filling the contact holes (241) to form electrical contacts (251) with the second electrode structure (230).

2. The resistor-capacitor component (200) according to claim 1, wherein each of the contact holes (241) delimits a corrugated circular opening onto the second electrode structure (230).

3. The resistor-capacitor component (200) according to claim 1 or 2, wherein corrugations (241-1) of the edges of the contact holes (241) are formed by alternating protrusions (241-2) and recesses (242-3), each of the corrugations (241-1) comprising a protrusion (241-2) and a recess (241-3).

4. The resistor-capacitor component (200) according to claim 3, wherein a ratio between: a distance between two consecutive corrugations (241-1) and a diameter of the contact holes (241) is equal to or less than 30%.

5. The resistor-capacitor component (200) according to claim 3 or 4, wherein the protrusions (241-2) and recesses (241-3) of the corrugations (241-1) of the edges of the contact holes (241) substantially form semi-circles or arcs of circles.

6. The resistor-capacitor component (200) according to any one of claims 1 to 5, wherein the capacitor is a three-dimensional capacitor.

7. The resistor-capacitor component (200) according to claim 6, wherein the first electrode structure (210) comprises a semiconductor substrate (212) with trenches, columns or holes (213), the dielectric structure (220) extending conformally on the trenches, columns, or holes (213) of the semiconductor substrate (212), and the second electrode structure (230) extending conformally on the dielectric structure (220).

8. The resistor-capacitor component (200) according to claim 6, wherein the first electrode structure (210') comprises an anodic aluminum oxide substrate (212') with pores (213') and a metal layer (214') extending conformally on the pores (213') of the anodic aluminum oxide substrate (212'), the dielectric structure (220') extending conformally on the metal layer (214'), and the second electrode structure (230') extending conformally on the dielectric structure (220').

9. The resistor-capacitor component (200) according to any one of claims 1 to 8, wherein the resistor-capacitor component (200) is configured to be used in an electrical circuit connected to a power supply whose voltage exceeds 600V, 900V or 1200V.

10. An electrical device (100) comprising the resistor-capacitor component (200) according to any one of claims 1 to 9 and a transistor component (300), and wherein the resistor-capacitor component (200) and the transistor component (300) are assembled on a support (400) and are electrically connected.

11. A power inverter (800) comprising the electrical device (100) according to claim 10.

12. A photomask (700, 700') for manufacturing a resistor-capacitor component (200) according to claim 1, the photomask (700, 700') comprising:
- an opaque region (710), and transparent regions (720) distributed across a surface of the photomask (700), each of the transparent regions (720) having a corrugated edge; or
- a transparent region (710'), and opaque regions (720') distributed across a surface of the photomask (700'), each of the opaque regions (720') having a corrugated edge.

13. A method for manufacturing a resistor-capacitor component (200), the method comprising:
- obtaining a capacitor comprising at least a first electrode structure (210) and a second electrode structure (230) separated by a dielectric structure (220);
- forming an insulating layer (240) on the second electrode structure (230), the insulating layer (240) comprising contact holes (241) distributed across a surface of the insulating layer (240), each of the contact holes (241) delimiting an opening onto the second electrode structure (230) having a corrugated edge; and
- forming a conductive layer (250) on the insulating layer (240), the conductive layer (250) filling the contact holes (241) to form electrical contacts (251) with the second electrode structure (230).

14. The method according to claim 13, comprising setting, using numerical simulations, a number and an area of the contact holes (241) based on targeted parameters of the resistor-capacitor component (200) including: a resistance; a bandwidth; and a maximum temperature reached for a given power and frequency of voltage spikes.

15. The method according to claim 13 or 14, comprising setting, using numerical simulations, a number (N) and a depth (D) of the corrugations (241-1) of the edges of the contact holes (241) to minimize a maximum temperature reached by the resistor-capacitor component (200) for a given power and frequency of voltage spikes.

## Patentansprüche

1. Widerstands-Kondensator-Bauelement (200), umfassend:
- einen Kondensator, der mindestens eine erste Elektrodenstruktur (210) und eine zweite Elektrodenstruktur (230) umfasst, die durch eine dielektrische Struktur (220) getrennt ist,
- eine Isolierschicht (240) auf der zweiten Elektrodenstruktur (230), wobei die Isolierschicht (240) Kontaktlöcher (241) umfasst, die über eine Oberfläche der Isolierschicht (240) verteilt sind, wobei jedes der Kontaktlöcher (241) eine Öffnung auf die zweite Elektrodenstruktur (230) begrenzt, die einen gewelltem Rand aufweist; und
- eine leitfähige Schicht (250) auf der Isolierschicht (240), die die Kontaktlöcher (241) füllt, um elektrische Kontakte (251) mit der zweiten Elektrodenstruktur (230) zu bilden.

2. Widerstands-Kondensator-Bauelement (200) nach Anspruch 1, wobei jedes der Kontaktlöcher (241) eine gewellte kreisförmige Öffnung auf die zweite Elektrodenstruktur (230) begrenzt.

3. Widerstands-Kondensator-Bauelement (200) nach Anspruch 1 oder 2, wobei Wellen (241-1) der Ränder der Kontaktlöcher (241) durch alternierende Vorsprünge (241-2) und Vertiefungen (242-3) gebildet werden, wobei jede der Wellen (241-1) einen Vorsprung (241-2) und eine Vertiefung (241-3) umfasst.

4. Widerstands-Kondensator-Bauelement (200) nach Anspruch 3, wobei ein Verhältnis zwischen: einem Abstand zwischen zwei aufeinanderfolgenden Wellen (241-1) und einem Durchmesser der Kontaktlöcher (241) gleich wie oder weniger als 30 % beträgt.

5. Widerstands-Kondensator-Bauelement (200) nach Anspruch 3 oder 4, wobei die Vorsprünge (241-2) und Vertiefungen (241-3) der Wellen (241-1) der Ränder der Kontaktlöcher (241) im Wesentlichen Halbkreise oder Flächen von Kreisen bilden.

6. Widerstands-Kondensator-Bauelement (200) nach einem der Ansprüche 1 bis 5, wobei der Kondensator ein dreidimensionaler Kondensator ist.

7. Widerstands-Kondensator-Bauelement (200) nach Anspruch 6, wobei die erste Elektrodenstruktur (210) ein Halbleitersubstrat (212) mit Gräben, Säulen oder Löchern (213) umfasst, wobei sich die dielektrische Struktur (220) konform auf den Gräben, Säulen oder Löchern (213) des Halbleitersubstrats (212) erstreckt und sich die zweite Elektrodenstruktur (230) konform auf der dielektrischen Struktur (220) erstreckt.

8. Widerstands-Kondensator-Bauelement (200) nach Anspruch 6, wobei die erste Elektrodenstruktur (210') ein anodisches Aluminiumoxidsubstrat (212') mit Poren (213') und einer Metallschicht (214') umfasst, die sich konform auf den Poren (213') des anodischen Aluminiumoxidsubstrats (212') erstreckt, wobei sich die dielektrische Struktur (220') konform auf der Metallschicht (214') erstreckt und die zweite Elektrodenstruktur (230') konform auf der dielektrischen Struktur (220') erstreckt.

9. Widerstands-Kondensator-Bauelement (200) nach einem der Ansprüche 1 bis 8, wobei das Widerstands-Kondensator-Bauelement (200) konfiguriert ist, um in einem Stromkreis verwendet zu werden, der an eine Stromversorgung angeschlossen ist, deren Spannung 600V, 900V oder 1200V übersteigt.

10. Elektrische Vorrichtung (100), umfassend das Widerstands-Kondensator-Bauelement (200) nach einem der Ansprüche 1 bis 9 und einen Transistorbauelements (300), und wobei das Widerstands-Kondensator-Bauelement (200) und das Transistorbaelement (300) auf einem Träger (400) montiert und elektrisch verbunden sind.

11. Wechselrichter (800), umfassend die elektrische Vorrichtung (100) nach Anspruch 10.

12. Fotomaske (700, 700') zur Herstellung eines Widerstands-Kondensator-Bauelements (200) nach Anspruch 1, wobei die Fotomaske (700, 700') Folgendes umfasst:
- einen undurchsichtigen Bereich (710) und transparente Bereiche (720), die über eine Oberfläche der Fotomaske (700) verteilt sind, wobei jeder der transparenten Bereiche (720) einen gewellten Rand aufweist; oder
- einen transparenten Bereich (710') und undurchsichtige Bereiche (720'), die über eine Oberfläche der Fotomaske (700') verteilt sind, wobei jeder der undurchsichtigen Bereiche (720') einen gewellten Rand aufweist.

13. Verfahren zur Herstellung eines Widerstands-Kondensator-Bauelements (200), wobei das Verfahren Folgendes umfasst:
- Erhalten eines Kondensators, der mindestens eine erste Elektrodenstruktur (210) und eine zweite Elektrodenstruktur (230) umfasst, die durch eine dielektrische Struktur (220) getrennt ist;
- Bilden einer Isolierschicht (240) auf der zweiten Elektrodenstruktur (230), wobei die Isolierschicht (240) Kontaktlöcher (241) umfasst, die über eine Oberfläche der Isolierschicht (240) verteilt sind, wobei jedes der Kontaktlöcher (241) eine Öffnung auf die zweite Elektrodenstruktur (230) begrenzt, die einen gewellten Rand aufweist; und
- Bilden einer leitfähigen Schicht (250) auf der Isolierschicht (240), wobei die leitfähige Schicht (250) die Kontaktlöcher (241) füllt, um elektrische Kontakte (251) mit der zweiten Elektrodenstruktur (230) zu bilden.

14. Verfahren nach Anspruch 13, umfassend Einstellen, unter Verwendung numerischer Simulationen, einer Anzahl und einer Fläche der Kontaktlöcher (241), basierend auf Zielparametern des Widerstands-Kondensator-Bauelements (200), darin eingeschlossen: einen Widerstand; eine Bandbreite; und eine maximale Temperatur, die bei einer bestimmten Leistung und Frequenz von Spannungsspitzen erreicht wird.

15. Verfahren nach Anspruch 13 oder 14, umfassend Einstellen, unter Verwendung numerischer Simulationen, einer Anzahl (N) und einer Tiefe (D) der Wellen (241-1) der Ränder der Kontaktlöcher (241), um eine maximale Temperatur zu minimieren, die vom Widerstands-Kondensator-Bauelement (200) bei einer bestimmten Leistung und Frequenz von Spannungsspitzen erreicht wird.

## Revendications

1. Composant résistance-condensateur (200) comprenant :
- un condensateur comprenant au moins une première structure d'électrode (210) et une deuxième structure d'électrode (230) séparées par une structure diélectrique (220) ;
- une couche isolante (240) sur la deuxième structure d'électrode (230), la couche isolante (240) comprenant des trous de contact (241) répartis sur une surface de la couche isolante (240), chacun des trous de contact (241) délimitant une ouverture sur la deuxième structure d'électrode (230) ayant un bord ondulé ; et
- une couche conductrice (250) sur la couche isolante (240) et remplissant les trous de contact (241) pour former des contacts électriques (251) avec la deuxième structure d'électrode (230).

2. Composant résistance-condensateur (200) selon la revendication 1, dans lequel chacun des trous de contact (241) délimite une ouverture circulaire ondulée sur la deuxième structure d'électrode (230).

3. Composant résistance-condensateur (200) selon la revendication 1 ou 2, dans lequel les ondulations (241-1) des bords des trous de contact (241) sont formées par des saillies (241-2) et des creux (242-3) en alternance, chacune des ondulations (241-1) comprenant une saillie (241-2) et un creux (241-3).

4. Composant résistance-condensateur (200) selon la revendication 3, dans lequel un rapport entre : une distance entre deux ondulations (241-1) consécutives et un diamètre des trous de contact (241) est inférieur ou égal à 30 %.

5. Composant résistance-condensateur (200) selon la revendication 3 ou 4, dans lequel les saillies (241-2) et les creux (241-3) des ondulations (241-1) des bords des trous de contact (241) forment sensiblement des demi-cercles ou des arcs de cercles.

6. Composant résistance-condensateur (200) selon l'une quelconque des revendications 1 à 5, dans lequel le condensateur est un condensateur tridimensionnel.

7. Composant résistance-condensateur (200) selon la revendication 6, dans lequel la première structure d'électrode (210) comprend un substrat semi-conducteur (212) avec des tranchées, des colonnes ou des trous (213), la structure diélectrique (220) s'étendant de manière conforme sur les tranchées, les colonnes ou les trous (213) du substrat semi-conducteur (212), et la deuxième structure d'électrode (230) s'étendant de manière conforme sur la structure diélectrique (220).

8. Composant résistance-condensateur (200) selon la revendication 6, dans lequel la première structure d'électrode (210') comprend un substrat d'oxyde d'aluminium anodique (212') avec des pores (213') et une couche métallique (214') s'étendant de manière conforme sur les pores (213') du substrat d'oxyde d'aluminium anodique (212'), la structure diélectrique (220') s'étendant de manière conforme sur la couche métallique (214'), et la deuxième structure d'électrode (230') s'étendant de manière conforme sur la structure diélectrique (220').

9. Composant résistance-condensateur (200) selon l'une quelconque des revendications 1 à 8, dans lequel le composant résistance-condensateur (200) est configuré pour être utilisé dans un circuit électrique connecté à une alimentation électrique dont la tension dépasse 600 V, 900 V ou 1200 V.

10. Dispositif électrique (100) comprenant le composant résistance-condensateur (200) selon l'une quelconque des revendications 1 à 9 et un composant transistor (300), et dans lequel le composant résistance-condensateur (200) et le composant transistor (300) sont assemblés sur un support (400) et sont connectés électriquement.

11. Onduleur (800) comprenant le dispositif électrique (100) selon la revendication 10.

12. Photomasque (700, 700') pour la fabrication d'un composant résistance-condensateur (200) selon la revendication 1, le photomasque (700, 700') comprenant :
- une région opaque (710), et des régions transparentes (720) réparties sur une surface du photomasque (700), chacune des régions transparentes (720) ayant un bord ondulé ; ou
- une région transparente (710'), et des régions opaques (720') réparties sur une surface du photomasque (700'), chacune des régions opaques (720') ayant un bord ondulé.

13. Procédé de fabrication d'un composant résistance-condensateur (200), le procédé comprenant :
- l'obtention d'un condensateur comprenant au moins une première structure d'électrode (210) et une deuxième structure d'électrode (230) séparées par une structure diélectrique (220) ;
- la formation d'une couche isolante (240) sur la deuxième structure d'électrode (230), la couche isolante (240) comprenant des trous de contact (241) répartis sur une surface de la couche isolante (240), chacun des trous de contact (241) délimitant une ouverture sur la deuxième structure d'électrode (230) ayant un bord ondulé ; et
- la formation d'une couche conductrice (250) sur la couche isolante (240), la couche conductrice (250) remplissant les trous de contact (241) pour former des contacts électriques (251) avec la deuxième structure d'électrode (230).

14. Procédé selon la revendication 13, comprenant la définition, à l'aide de simulations numériques, d'un nombre et d'une surface des trous de contact (241) sur la base de paramètres ciblés du composant résistance-condensateur (200) incluant : une résistance ; une largeur de bande ; et une température maximale atteinte pour une puissance donnée et pour une fréquence de pics de tension.

15. Procédé selon la revendication 13 ou 14, comprenant la définition, à l'aide de simulations numériques, d'un nombre (N) et d'une profondeur (D) des ondulations (241-1) des bords des trous de contact (241) pour minimiser une température une température maximale atteinte par le composant résistance-condensateur (200) pour une puissance donnée et pour une fréquence de pics de tension.
